# FASCICULE DE BREVET EUROPEEN

(11) **EP 1 979 938 B1**
(45) Date de publication et mention de la délivrance du brevet: **06.08.2014**
(21) Numéro de dépôt: 07731538.0
(22) Date de dépôt: 30.01.2007
(51) Int. Cl.: H01L 21/60, H01L 23/495

(54) **MODULE ELECTRONIQUE ET PROCEDE D'ASSEMBLAGE D'UN TEL MODULE**
ELEKTRONISCHES MODUL UND VERFAHREN ZUR MONTAGE EINES DERARTIGEN MODULS
ELECTRONIC MODULE AND A METHOD OF ASSEMBLING SUCH A MODULE

(30) Priorité: 30.01.2006 FR 0600841
(43) Date de publication de la demande: 15.10.2008
(73) Titulaire: Valeo Etudes Electroniques, 94042 Créteil Cédex (FR)
(72) Inventeur: MORELLE, Jean-Michel, F-45190 Beaugency (FR); VIVET, Laurent, F-78390 Bois D'arcy (FR); MEDINA, Mathieu, 16 rue des As, 33600 Pessac (FR); LEON, Renan, F-78000 Versailles (FR)
(74) Mandataire: Cardon, Nicolas
(86) Numéro de dépôt international: PCT/FR2007/050710
(87) Numéro de publication internationale: WO 2007/085774

(56) Documents cités:
- WO-A2-2004/100258
- US-A- 4 606 962
- US-A- 4 759 994
- US-A- 5 069 978
- US-A- 5 438 477
- US-A- 6 063 648
- US-A1- 2005 087 881

## Description

La présente invention concerne un module électronique et un procédé d'assemblage d'un tel module.

Elle s'applique en particulier à un module de puissance pour véhicule automobile réalisant par exemple des fonctions de commutation.

On connaît plus particulièrement, dans l'état de la technique, notamment d'après WO 2004/100258. un module du type comprenant un composant électronique muni d'une face conductrice reliée électriquement à un organe de raccordement du composant au moyen d'un conducteur au moins partiellement ondulé de façon à délimiter une alternance d'arches opposées, une première série d'arches étant reliée à la face conductrice du composant électronique.

Dans un tel module, le composant électronique comprend par exemple une pastille semi-conductrice, agencée sur un substrat. La face conductrice est généralement métallisée, par exemple recouverte d'un film métallique.

L'organe de raccordement comprend par exemple des moyens de connexion du composant avec son environnement, des moyens de dissipation thermique ou un second composant électronique.

Un module de puissance pour véhicule automobile est traversé par des courants électriques d'intensité relativement élevée et est généralement installé dans un environnement soumis à des températures élevées.

On souhaite donc que le module dégage le moins de chaleur possible, et, par conséquent, que sa résistance soit la moins élevée possible, dans le but d'éviter que le composant électronique soit endommagé en raison d'une température environnante trop élevée.

Dans ce but, le conducteur décrit dans WO 2004/100258 a une forme générale de ruban et comprend une première extrémité reliée à l'organe de raccordement et une seconde extrémité ondulée, délimitant l'alternance d'arches opposées.

Les arches de la première série sont soudées chacune sur la face conductrice du composant électronique de façon à établir de multiples zones de contact entre cette face et le conducteur.

Ces multiples zones de contact entre la face conductrice et le conducteur permettent de limiter la longueur du trajet du courant dans la face conductrice métallisée et, par conséquent, la résistance de celle-ci, et, ainsi, de limiter la dissipation de chaleur par cette face.

Toutefois, dans WO 2004/100258, le trajet du courant entre les deux extrémités du conducteur est relativement long si bien qu'une quantité relativement importante d'énergie est dissipée par effet Joule dans le conducteur, ce qui peut également engendrer une élévation importante de la température au voisinage du composant électronique.

L'invention a notamment pour but de diminuer de façon significative l'énergie dissipée par effet Joule dans le conducteur et donc la chaleur transmise au composant électronique, comme dans le document US 2005/0087831.

A cet effet, l'invention a pour objet un module conforme à la revendication 1.

Ainsi, la longueur du trajet parcouru par le courant qui circule du composant électronique vers l'organe de raccordement n'est plus égale à la longueur du conducteur mais à la longueur d'une moitié d'arche. La résistance du conducteur et l'énergie dissipée sous forme de chaleur par effet Joule étant directement proportionnelles à la longueur du trajet parcouru par le courant, le risque qu'une élévation de température due à la dissipation d'énergie par effet Joule dans le conducteur endommage le composant électronique est grandement diminué.

De plus, grâce à la première série d'arches, le conducteur est relié au composant électronique en de multiples zones réparties sur la face conductrice du composant électronique et par lesquelles se produit le passage du courant entre le composant et le conducteur. Ainsi, cette répartition des zones de passage du courant permet de distribuer la chaleur dissipée par effet Joule sur la face conductrice du composant et donc de limiter la température de ces zones. Cela permet de diminuer encore les risques d'endommager le composant électronique.

En outre, dans le module selon l'invention, grâce à la seconde série d'arches du conducteur, la surface de contact de ce conducteur avec l'organe de raccordement est plus importante que dans l'état de la technique. Or, de façon classique, l'organe de raccordement peut former des moyens de dissipation thermique et le conducteur conduit également la chaleur. Le module selon l'invention permet donc également une évacuation plus efficace de la chaleur au voisinage du composant électronique. Ainsi, les risques que ce composant soit endommagé sont encore diminués.

De plus, le module selon l'invention est moins volumineux et donc parfaitement adapté à la plupart des systèmes dans lesquels l'encombrement est un facteur primordial.

Optionnellement, le composant électronique comprend une pastille semi-conductrice.

Le module selon l'invention est particulièrement adapté à ce cas. En effet, les pastilles semi-conductrices sont très fragiles et ne peuvent pas être facilement connectées directement à d'autres éléments par des moyens connus (brasage, etc.), qui susceptibles d'endommager ces pastilles.

Le conducteur a une forme générale de ruban.

Cette forme permet d'augmenter la section du conducteur, et ainsi la surface de contact de celui-ci avec les différents éléments du module, sans pour autant augmenter de façon gênante l'encombrement du module.

En outre, le conducteur en forme de ruban ondulé possède des propriétés mécaniques appropriées, notamment une rigidité appropriée, pour former des moyens de support efficace de l'organe de raccordement.

Le conducteur est multicouche.

Ainsi, le conducteur comprend, une couche en un matériau particulièrement adapté pour la liaison avec le composant électronique, une couche en un matériau particulièrement adapté pour la liaison avec l'organe de raccordement et une couche en un matériau très conducteur, cette couche ayant pour objectif de diminuer encore la résistance du conducteur en diminuant notamment sa résistivité.

Optionnellement, les arches du conducteur ont une hauteur sensiblement constante.

Optionnellement, le module forme un module d'électronique de puissance pour un véhicule automobile.

La présente invention a également pour objet un procédé d'assemblage d'un module selon l'invention, le procédé comprenant au moins une étape de soudage de la première série d'arches du conducteur sur la face conductrice du composant électronique, le procédé comprenant ensuite une étape de positionnement de l'organe de raccordement au contact de la seconde série d'arches du conducteur, suivie d'une étape de liaison de l'organe de raccordement avec le conducteur.

Dans un premier mode de réalisation, l'étape de liaison de l'organe de raccordement avec le conducteur comporte une étape d'application d'une pression de maintien de cet organe de raccordement avec le conducteur.

Dans un second mode de réalisation, l'étape de liaison de l'organe de raccordement avec le conducteur comprend au moins une étape de soudage, avec ou sans apport de matière, de l'organe de raccordement au conducteur.

Un exemple de soudage sans apport de matière est le soudage par ultrasons. Un soudage avec apport de matière peut être un brasage.

Dans ce dernier cas, l'étape de liaison peut être précédée d'une étape de protection du composant électronique.

Cette protection peut être temporaire ou définitive et permet de protéger le composant électronique qui pourrait être endommagé par l'opération de liaison par soudage, par exemple en raison de projections de matière sur ce composant.

Dans un mode de réalisation particulier, l'étape de protection comprend une étape de dépôt d'une couche de polymère sur le composant électronique, de sorte que cette couche couvre la face conductrice de ce composant.

L'invention sera mieux comprise à la lecture de la description qui va suivre, donnée uniquement à titre d'exemple et faite en se référant aux dessins annexés dans lesquels :
- la figure 1 est une coupe longitudinale d'un module selon l'invention ;
- la figure 2 est une vue de dessus en perspective du module selon l'invention avant la liaison avec l'organe de raccordement.

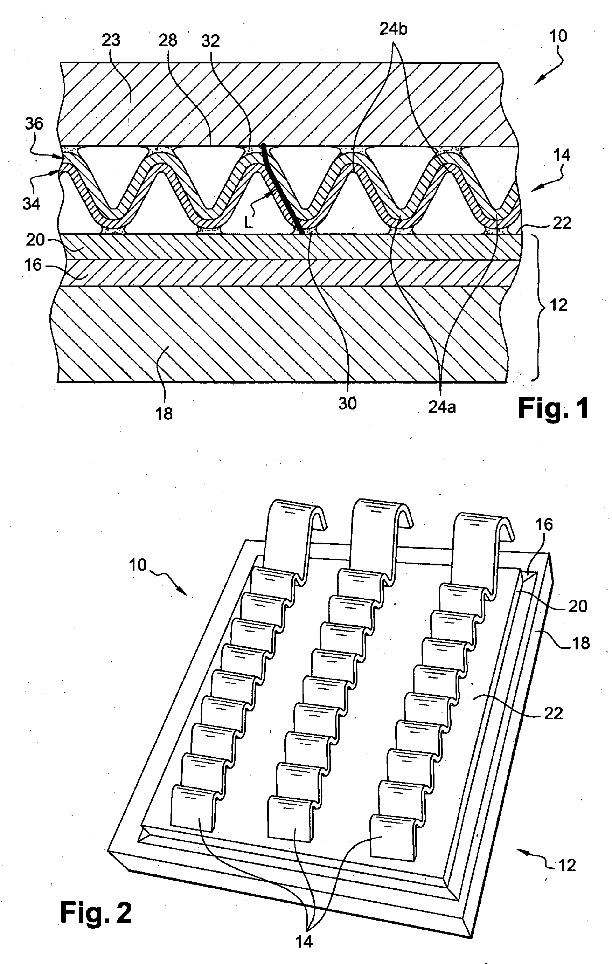

On a représenté sur les figures 1 et 2 un module 10 comprenant un composant électronique 12 et des conducteurs 14, par exemple au nombre de trois. Un tel module 10 est, dans l'exemple décrit, un module de puissance, utilisé par exemple dans un véhicule automobile.

Le composant électronique 12 comprend une pastille semi-conductrice 16, agencée sur un substrat 18, formant à la fois isolant électrique et dissipateur thermique. Le composant électrique peut être par exemple un transistor MOSFET ou JFET, non intégré. Cette pastille semi-conductrice 16 est recouverte d'un film métallique 20, formant une face conductrice 22 du composant 12, destinée à être connectée électriquement à d'autres éléments, comme un organe de raccordement 23.

L'organe de raccordement 23 est, dans cet exemple, un connecteur permettant de relier électriquement le composant électronique 12 à d'autres composants électroniques.

Les conducteurs 14 ont une forme générale de rubans et sont ondulés. Ils sont reliés à la face conductrice 22 et à l'organe de raccordement 23. Ils s'étendent longitudinalement sensiblement parallèlement entre eux.

Comme on le voit plus clairement sur la figure 1, chacun des conducteurs 14 délimite une alternance d'arches opposées 24a, 24b, ces arches ayant sensiblement la même hauteur.

Une première série d'arches 24a est en effet reliée à la face conductrice 22 du film métallique 20, et une seconde série d'arches 24b opposées aux arches 24a de la première série et intercalées entre ces arches 24a, est reliée à une face conductrice 28 de l'organe de raccordement 23.

Les faces 22 et 28 sont sensiblement parallèles entre elles et matérialisent deux plans parallèles de contact avec les conducteurs 14, affleurant avec les sommets des arches 24a, 24b.

Ainsi, le ruban conducteur comprend au moins une zone 30 en contact avec la face conductrice 22 et au moins une zone 32 en contact avec la face conductrice 28 de l'organe de raccordement 23. Les zones 30, 32 sont toutes au même potentiel.

Chaque conducteur 14 est également multicouche. Plus particulièrement, il comporte une couche 34 d'aluminium en contact avec la face 22 du composant 12 et une couche 36 de cuivre en contact avec l'organe de raccordement 23. La couche de cuivre 36 confère au conducteur 14 une grande résistivité tout en étant compatible avec l'organe de raccordement 23. La couche d'aluminium 34 permet au conducteur d'être compatible avec le film métallique 20.

Dans le module selon l'invention et comme représenté plus particulièrement à la figure 1, le courant parcourt un trajet L très court dans le conducteur 14, de la longueur d'une moitié d'arche.

Ainsi, la résistance électrique du conducteur est grandement diminuée et l'énergie dissipée sous forme de chaleur dans le module est également diminuée. En outre, les multiples zones 32 de contact électrique et thermique entre le conducteur 14 et l'organe de raccordement 23, qui forme également un dissipateur thermique, permettent de réguler efficacement la chaleur au voisinage de la pastille semi-conductrice 16 et ainsi, d'éviter que celle-ci soit endommagée.

On notera que les conducteurs ondulés 14 forment également un support pour l'organe de raccordement 23.

On va maintenant décrire les étapes successives d'un procédé d'assemblage de ce module 10. Le procédé comprend tout d'abord une étape classique de soudage de la première série d'arches 24a du conducteur 14 sur la face conductrice 22 du composant électronique 12.

Le soudage est plus particulièrement un soudage par ultrasons. Ce type de soudage permet en effet de souder une zone du conducteur 14 d'aire très petite, de façon parfaitement contrôlée. Cela est donc particulièrement adapté pour le soudage sur le composant électronique 12 comprenant la pastille 16, qui est très fragile.

Le procédé comprend ensuite une étape de positionnement de l'organe de raccordement 23 au contact de la seconde série d'arches 24b de chaque conducteur 14.

Cette étape est suivie d'une étape de liaison de l'organe de raccordement 23 avec les conducteurs 14.

Cette liaison peut être, selon un premier mode de réalisation, uniquement électrique et thermique, c'est-à-dire transmettant l'électricité et la chaleur. Dans ce cas, l'étape de liaison peut consister à appliquer, sur l'organe de raccordement 23, une pression de maintien de cet organe de raccordement 23 avec le conducteur 14. En général, cette pression est appliquée par des moyens classiques élastiques selon une direction normale à la face conductrice 28 de l'organe de raccordement 23.

Selon un second mode de réalisation, la liaison entre l'organe de raccordement 23 et les conducteurs 14 peut être également mécanique, c'est-à-dire transmettant les contraintes mécaniques entres ces éléments 23 et 14. Dans ce cas, l'étape de liaison comprend une étape de soudage, par exemple une étape de brasage du conducteur 14 avec l'organe de raccordement 23. Le brasage peut être par exemple effectué à l'aide d'un alliage étain-plomb ou étain-argent.

Dans ce second mode de réalisation, l'étape de liaison peut être précédée par une étape de protection du composant 12 consistant, par exemple, à déposer une couche de polymère sur le composant électronique 12, de sorte que cette couche couvre la face conductrice 22 de ce composant 12. Cette face est ainsi protégée et le composant n'est pas endommagé durant l'étape de liaison, par exemple par les projections de matière dues au brasage. Toutefois, il est possible que la protection du composant 12 soit uniquement temporaire et soit mise en oeuvre différemment.

On notera que le module et le procédé d'assemblage de ce module ne sont pas limités aux modes de réalisation décrits ci-dessus.

En variante, les faces conductrices 22, 28 du film métallique 20 et de l'organe de raccordement 23 pourraient ne pas être parallèles, les arches 24a, 24b n'étant alors pas sensiblement de même hauteur. Par ailleurs, la liaison de l'organe de raccordement avec le conducteur pourrait être réalisée par soudage autogène.

## Revendications

1. Module (10) comprenant un composant électronique (12) muni d'une face conductrice (22) reliée électriquement à un organe de raccordement (23) du composant (12) au moyen d'un conducteur (14) avant une forme générale de ruban au moins partiellement ondulé de façon à délimiter une alternance d'arches opposées (24a, 24b), une première série d'arches (24a) étant reliée à la face conductrice (22) du composant électronique (12), le conducteur comprenant une seconde série d'arches (24b) opposées aux arches (24a) de la première série et intercalées entre les arches (24a) de la première série, cette seconde série d'arches (24b) étant reliée à une face conductrice (28) de l'organe de raccordement (23), le module étant **caractérisé en ce que** le conducteur est multicouche.

2. Module (10) selon la revendication 1, le composant électronique (12) comprenant une pastille semi-conductrice (16).

3. Module (10) selon la revendication 1 ou 2, les arches (24a, 24b) du conducteur (14) ayant une hauteur sensiblement constante.

4. Module (10) selon l'une quelconque des revendications précédentes, le module formant un module de puissance pour un véhicule automobile.

5. Module (10) selon l'une quelconque des revendications précédentes, la première série d'arches du conducteur étant soudée au composant électronique.

6. Procédé d'assemblage d'un module selon l'une quelconque des revendications 1 à 5, le procédé comprenant au moins une étape de soudage de la première série d'arches (24a) du conducteur (14) sur la face conductrice (22) du composant électronique (12), le procédé comprenant ensuite une étape de positionnement de l'organe de raccordement (23) au contact de la seconde série d'arches (24b) du conducteur (14), suivie d'une étape de liaison de l'organe de raccordement (23) avec le conducteur (14).

7. Procédé selon la revendication 6, l'étape de liaison de l'organe de raccordement (23) avec le conducteur (14) comportant une étape d'application, sur l'organe de raccordement (23), d'une pression de maintien de cet organe de raccordement (23) avec le conducteur (14).

8. Procédé selon la revendication 6, l'étape de liaison de l'organe de raccordement (23) avec le conducteur (14) comprenant au moins une étape de soudage, avec ou sans apport de matière, de l'organe de raccordement (23) avec le conducteur (14).

9. Procédé selon la revendication 8, l'étape de liaison étant précédée d'une étape de protection du composant électronique (12).

10. Procédé selon la revendication 9, l'étape de protection comprenant une étape de dépôt d'une couche de polymère sur le composant électronique (12), de sorte que cette couche couvre la face conductrice (22) de ce composant (12).

## Patentansprüche

1. Modul (10), das eine elektronische Komponente (12) umfasst, die mit einer leitenden Fläche (22) versehen ist, die mit einem Verbindungsorgan (23) der Komponente (12) mittels eines Leiters (14) elektrisch verbunden ist, der die allgemeine Form eines Bandes besitzt, das wenigstens teilweise gewellt ist, derart, dass eine Wechselfolge gegenüberliegender Bögen (24a, 24b) begrenzt wird, wobei eine erste Reihe von Bögen (24a) mit der leitenden Fläche (22) der elektronischen Komponente (12) verbunden ist, wobei der Leiter eine zweite Reihe von Bögen (24b) gegenüber den Bögen (24a) der ersten Reihe umfasst, die mit den Bögen (24a) der ersten Reihe verschachtelt sind, wobei diese zweite Reihe von Bögen (24b) mit einer leitenden Fläche (28) des Verbindungsorgans (23) verbunden ist, wobei das Modul **dadurch gekennzeichnet ist, dass** der Leiter mehrschichtig ist.

2. Modul (10) nach Anspruch 1, wobei die elektronische Komponente (12) einen Halbleiterchip (16) umfasst.

3. Modul (10) nach Anspruch 1 oder 2, wobei die Bögen (24a, 24b) des Leiters (14) eine im Wesentlichen konstante Höhe haben.

4. Modul (10) nach einem der vorhergehenden Ansprüche, wobei das Modul ein Leistungsmodul für ein Kraftfahrzeug bildet.

5. Modul (10) nach einem der vorhergehenden Ansprüche, wobei die erste Reihe von Bögen des Leiters an die elektronische Komponente geschweißt ist.

6. Verfahren zum Montieren eines Moduls nach einem der Ansprüche 1 bis 5, wobei das Verfahren wenigstens einen Schritt des Schweißens der ersten Reihe von Bögen (24a) des Leiters (14) an die leitende Fläche (22) der elektronischen Komponente (12) umfasst, wobei das Verfahren anschließend einen Schritt des Positionierens des Verbindungsorgans (23) in einem Kontakt der zweiten Reihe von Bögen (24b) des Leiters (14) umfasst, gefolgt von einem Schritt des Verbindens des Verbindungsorgans (23) mit dem Leiter (14).

7. Verfahren nach Anspruch 6, wobei der Schritt des Verbindens des Verbindungsorgans (23) mit dem Leiter (14) einen Schritt des Ausübens eines Drucks zum Halten des Verbindungsorgans (23) an dem Leiter (14) auf dieses Verbindungsorgan (23) umfasst.

8. Verfahren nach Anspruch 6, wobei der Schritt des Verbindens des Verbindungsorgans (23) mit dem Leiter (14) wenigstens einen Schritt des Verschweißens mit oder ohne Materialeintrag des Verbindungsorgans (23) mit dem Leiter (14) umfasst.

9. Verfahren nach Anspruch 8, wobei dem Verbindungsschritt ein Schritt zum Schützen der elektronischen Komponente (12) vorhergeht.

10. Verfahren nach Anspruch 9, wobei der Schutzschritt einen Schritt des Ablagerns einer Polymerschicht auf der elektronischen Komponente (12) umfasst, derart, dass diese Schicht die leitende Fläche (22) dieser Komponente (12) abdeckt.

## Claims

1. Module (10) comprising an electronic component (12) provided with a conductive face (22) linked electrically to a connection member (23) of the component (12) by means of a conductor (14) in the general form of a strip which is at least partially corrugated so as to delimit an alternation of opposing arches (24a, 24b), a first series of arches (24a) being linked to the conductive face (22) of the electronic component (12), the conductor comprising a second series of arches (24b) opposite the arches (24a) of the first series and inserted between the arches (24a) of the first series, this second series of arches (24b) being linked to a conductive face (28) of the connection member (23), the module being **characterized in that** the conductor is multilayer.

2. Module (10) according to Claim 1, the electronic component (12) comprising a semiconductive pad (16).

3. Module (10) according to Claim 1 or 2, the arches (24a, 24b) of the conductor (14) having a substantially constant height.

4. Module (10) according to any one of the preceding claims, the module forming a power module for a motor vehicle.

5. Module (10) according to any one of the preceding claims, the first series of arches of the conductor being soldered to the electronic component.

6. Method for assembling a module according to any one of Claims 1 to 5, the method comprising at least one step of soldering the first series of arches (24a) of the conductor (14) onto the conductive face (22) of the electronic component (12), the method then comprising a step of positioning the connection member (23) in contact with the second series of arches (24b) of the conductor (14), followed by a step of linking the connection member (23) with the conductor (14).

7. Method according to Claim 6, the step of linking the connection member (23) with the conductor (14) comprising a step of applying, to the connection member (23), a pressure for securing this connection member (23) with the conductor (14).

8. Method according to Claim 6, the step of linking the connection member (23) with the conductor (14) comprising at least one step of soldering, with or without the addition of material, the connection member (23) with the conductor (14).

9. Method according to Claim 8, the linking step being preceded by a step of protecting the electronic component (12).

10. Method according to Claim 9, the protecting step comprising a step of depositing a layer of polymer on the electronic component (12), so that this layer covers the conductive face (22) of this component (12).
